# EUROPÄISCHE PATENTSCHRIFT

(11) **EP 1 908 132 B1**
(45) Veröffentlichungstag und Bekanntmachung des Hinweises auf die Patenterteilung: **26.08.2009**
(21) Anmeldenummer: 06777989.2
(22) Anmeldetag: 26.07.2006
(51) Int. Cl.: H01L 41/083, H01L 41/047

(54) **MONOLITHISCHER PIEZOAKTOR MIT DREHUNG DER POLARISATIONSRICHTUNG IM ÜBERGANGSBEREICH SOWIE VERWENDUNG DES PIEZOAKTORS**
MONOLITHIC PIEZOACTUATOR WITH ROTATION OF THE POLARISATION IN THE TRANSITION REGION AND USE OF SAID PIEZOACTUATOR
ACTIONNEUR PIEZO-ELECTRIQUE MONOLITHE A ROTATION DU SENS DE POLARISATION DANS LA ZONE DE TRANSITION ET UTILISATION DUDIT ACTIONNEUR PIEZO-ELECTRIQUE

(30) Priorität: 26.07.2005 DE 102005034814
(43) Veröffentlichungstag der Anmeldung: 09.04.2008
(73) Patentinhaber: SIEMENS AKTIENGESELLSCHAFT, 80333 München (DE)
(72) Erfinder: KASTL, Harald Johannes, 95686 Fichtelberg (DE); SCHUH, Carsten, 85598 Baldham (DE)
(86) Internationale Anmeldenummer: PCT/EP2006/064682
(87) Internationale Veröffentlichungsnummer: WO 2007/012654

(56) Entgegenhaltungen:
- DE-A1- 10 307 825
- DE-A1- 19 928 178
- DE-A1-102004 012 282
- DE-A1-102004 026 572

## Beschreibung

Die Erfindung betrifft einen Piezoaktor in monolithischer Vielschichtbauweise, aufweisend mindestens einen piezoelektrisch aktiven Teilstapel, wobei der Teilstapel übereinander angeordnete Piezokeramikschichten mit piezokeramischem Werkstoff und zwischen den Piezokeramikschichten angeordnete Elektrodenschichten (Innenelektroden) aufweist, mindestens einen, über dem piezoelektrisch aktiven Teilstapel angeordneten piezoelektrisch inaktiven Abschlussbereich und mindestens einen zwischen dem piezoelektrisch aktiven Teilstapel und dem Abschlussbereich angeordneten Übergangsbereich, wobei der piezoelektrisch aktive Teilstapel, der Abschlussbereich und der Übergangsbereich zu einem monolithischen Gesamtstapel miteinander verbunden sind. Neben dem Piezoaktor wird eine Verwendung des Piezoaktors angegeben.

Bei der erstmaligen elektrischen Ansteuerung solcher Piezoaktoren bis in den Großsignalbereich (Feldstärken von mehreren kV/mm) wird der piezokeramische Werkstoff gepolt. Dabei resultiert eine irreversible Längenänderung, die so genannte remanente Dehnung. Aufgrund der remanenten Dehnung und aufgrund einer zusätzlichen Dehnung, die bei elektrischer Ansteuerung der Elektrodenschichten im Betrieb des Piezoaktors auftritt, entstehen im Gesamtstapel Zugspannungen. Diese Zugspannungen führen dazu, dass im Verlauf der Polung oder im Betrieb des Piezoaktors beispielsweise entlang einer Grenzfläche zwischen einer Piezokeramikschicht und einer Elektrodenschicht Risse (Polungsrisse) entstehen. Solche Risse treten insbesondere auch im Übergangsbereich zwischen aktivem Teilstapel und Abschlussbereich auf. Besonders schädlich sind dabei sich verzweigende oder sich in Längsrichtung des Gesamtstapels ausbreitende Risse. Solche Risse führen unweigerlich zu vorzeitigem Ausfall des Piezoaktors.

DE 10 2004 026 571 A1 offenbert einen Pietuaktor in monolithischer Vielschichtbauweise gemäß dem Oberbegriff der Anspruchs 1. Ein ähnlicher Vielschichtaktor ist DE 103 07 825 A1 zu entnehmen.

Aufgabe der Erfindung ist es, einen Piezoaktor anzugeben, bei dem die Wahrscheinlichkeit für die Bildung der oben beschriebenen Risse und deren Wachstum im Vergleich zum Stand der Technik verringert ist.

Zur Lösung der Aufgabe wird ein Piezoaktor in monolithischer Vielschichtbauweise angegeben, aufweisend mindestens einen piezoelektrisch aktiven Teilstapel, wobei der Teilstapel übereinander angeordnete Piezokeramikschichten und zwischen den Piezokeramikschichten angeordnete Elektrodenschichten aufweist, mindestens einen, über dem piezoelektrisch aktiven Teilstapel angeordneten piezoelektrisch inaktiven Abschlussbereich und mindestens einen zwischen dem piezoelektrisch aktiven Teilstapel und dem Abschlussbereich angeordneten Übergangsbereich, wobei der piezoelektrisch aktive Teilstapel, der Abschlussbereich und der Übergangsbereich zu einem monolithischen Gesamtstapel miteinander verbunden sind. Der Piezoaktor ist **dadurch gekennzeichnet, dass** der Übergangsbereich einen Übergangsbereichs-Stapel mit übereinander angeordneten Übergangsbereichs-Piezokeramikschichten und zwischen den Übergangsbereichs-Piezokeramikschichten angeordneten Übergangsbereichs-Elektrodenschichten aufweist und die Übergangsbereichs-Piezokeramikschichten und die Übergangsbereichs-Elektrodenschichten derart ausgestaltet und aneinander angeordnet sind, dass in Stapelrichtung des Übergangsbereichs-Stapels von Übergangsbereichs-Piezokeramikschicht zu Übergangsbereichs-Piezokeramikschicht sukzessive eine Drehung einer Hauptachse der Polung und/oder eine Drehung einer Hauptachse der elektrischen Ansteuerung vorhanden ist. Die Hauptachse betrifft die Polarisationsvektor bzw. den Vektor des elektrischen Feldes, das durch die elektrische Ansteuerung hervorgerufen und jeweils in die Übergangsbereichs-Piezokeramikschicht eingekoppelt wird. Dabei kann durchaus vorgesehen sein, dass

die Hauptachsen zweier oder mehrere, direkt übereinander gestapelter Piezokeramikschichten gleich ausgerichtet sind. Diese Piezokeramikschichten bilden ein Paket von Piezokeramikschichten mit gleich ausgerichteter Hauptachse der Polung.

Der Abschlussbereich kann ein Kopf- oder Fußbereich des Gesamtstapels sein. Der Abschlussbereich kann aus einer Schicht oder aus mehreren Schichten bestehen. Im letzteren Fall wird von einem Deckpaket gesprochen. Als Material des Abschlussbereichs kommen keramische oder metallische Materialien in Frage.

Die Hauptachse der elektrischen Ansteuerung definiert die Hauptachse des elektrischen Feldes, das durch die Ansteuerung in die Übergangs-Piezokeramikschicht induziert wird.

Ein piezokeramischer Werkstoff der Piezokeramikschichten und ein piezokeramischer Werkstoff der Übergangsbereichs-Piezokeramikschichten können gleich sein. Es können aber auch unterschiedliche Werkstoffe verwendet werden. Ebenso können die Schichtdicken dieser Schichten gleich oder unterschiedlich sein.

Die grundlegende Idee der Erfindung besteht darin, einen Übergangsbereich mit Gradierung der Dehnung der Übergangs-Piezokeramikschichten bereitzustellen. Durch die Gradierung werden die aus dem Stand der Technik bekannten hohen Zugspannungen zwischen piezoelektrisch aktivem Teilstapel und piezoelektrisch inaktivem Abschlussbereich deutlich reduziert.

Gemäß einer besonderen Ausgestaltung umfasst die Drehung der jeweiligen Hauptachse eine Drehung der Hauptachse von einer im Wesentlichen zur Stapelrichtung des Übergangsbereichs-Teilstapels parallelen Ausrichtung in eine im Wesentlichen zur Stapelrichtung des Übergangsbereichs-Teilstapels senkrechte Ausrichtung. Im Wesentlichen bedeutet dabei, dass keine exakte senkrechte bzw. parallele Ausrichtung vorhanden sein muss. Abweichungen von bis zu 50% sind denkbar.

Durch die Drehung wird eine Änderung der während des Polarisierens oder während des Betriebs auftretenden Dehnung bewirkt. Die resultierende Dehnung in der lateralen Richtung (a/b-Richtung) und die resultierende Dehnung in der Stapelrichtung (c-Richtung) setzen sich nicht mehr rein aus den d₃₁ (negativ) - und d₃₃ (positiv) -Anteilen zusammen. Es resultiert eine Überlagerung dieser Effekte. Bei bestimmten Richtungen eines Polungs- und Ansteuervektors zu den Schichtebenen wird eine minimale Dehnung in den jeweiligen Richtungen erreicht. Dies führt zu entsprechend geringen mechanischen Zugspannungen zwischen zwei Schichten des Übergangsbereichs.

Vorzugsweise ist die im Wesentlichen senkrechte Ausrichtung im Grenzbereich zwischen dem Übergangsbereichs-Teilstapel und dem Abschlussbereich angeordnet. Es kommt zur sukzessiven "Verschmierung" der Polarisation. Dies hat zur Folge, dass im Grenzbereich zwischen dem Übergangsbereich und dem inaktiven Abschlussbereich nur sehr geringe mechanische Spannungen auftreten. Die Wahrscheinlichkeit für das Auftreten eines Risses ist deutlich reduziert.

Gemäß einer besonderen Ausgestaltung ist die Drehung durch Änderung einer Struktur und/oder einer Abmessung der Übergangsbereichs-Elektrodenschichten hervorgerufen. Die Gradierung wird durch sukzessive Änderung der Übergangsbereichs-Elektrodenschichten hervorgerufen.

Dazu ist die Struktur der Übergangsbereichs-Elektrodenschicht zur lateralen Ausdehnung der jeweiligen Übergangsbereichs-Elektrodenschicht kammartig. In einer weiteren Ausgestaltung ist die Struktur parallel zur lateralen Ausdehnung der jeweiligen Übergangsbereichs-Elektrodenschicht kreisförmig. Insbesondere die kammartige Struktur eignet sich zur Ausbildung einer Interdigitalstruktur. Daher bilden gemäß einer besonderen Ausgestaltung benachbarte Übergangsbereichs-Elektrodenschichten eine Interdigital-Struktur.

Gemäß einer besonderen Ausgestaltung weist der aktive Teilstapel und/oder der Abschlussbereich eine aus dem Bereich von einschließlich 1 mm bis einschließlich 10 mm und insbesondere aus dem Bereich von einschließlich 3 mm bis einschließlich 5 mm ausgewählte Teilstapelhöhe aufweist. Beispielsweise beträgt die Teilstapelhöhe 2 mm. Es hat sich gezeigt, dass mit diesen Teilstapelhöhen Spannungsspitzen sehr gut abgebaut werden. Gemäß einer besonderen Ausgestaltung weist der Übergangsbereichs-Teilstapel eine aus dem Bereich von einschließlich 0,2 bis einschließlich 5,0 mm und insbesondere von einschließlich 0,5 bis einschließlich 2,0 mm ausgewählte Übergangsstapelhöhe auf. Mit den Teilstapeln sind sehr hohe Gesamtstapel zugänglich. In einer besonderen Ausgestaltung weist der Gesamtstapel eine Gesamtstapelhöhe auf, die aus dem Bereich von einschließlich 10 mm bis einschließlich 200 mm ausgewählt ist. Höhere Gesamtstapelhöhen sind ebenfalls zugänglich.

Dieser neue, zuverlässige Piezoaktor wird bevorzugt zur Ansteuerung eines Ventils und insbesondere eines Einspritzventils einer Brennkraftmaschine verwendet. Die Brennkraftmaschine ist beispielsweise ein Motor eines Kraftfahrzeugs.

Anhand mehrerer Ausführungsbeispiele und der dazugehörigen Figuren wird die Erfindung im Folgenden näher beschrieben. Die Figuren sind schematisch und stellen keine maßstabsgetreuen Abbildungen dar.

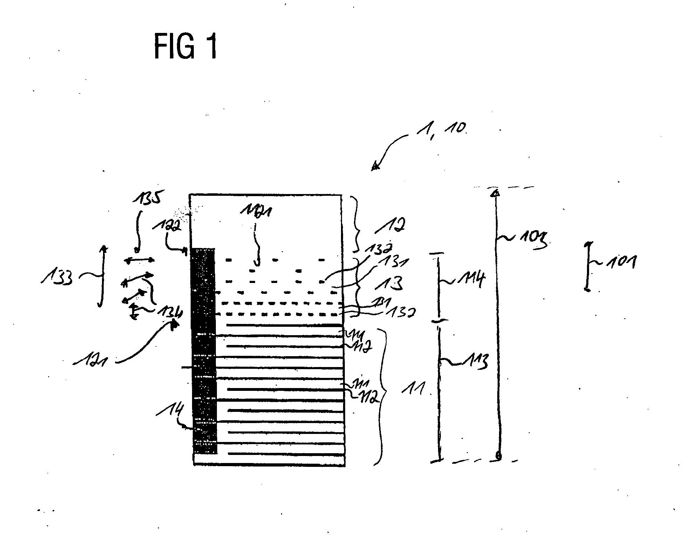

- Figur 1: zeigt einen Piezoaktor in monolithischer Vielschichtbauweise von der Seite.
- Figur 2A: zeigt eine sukzessive Änderung der kammartigen Struktur der Übergangsbereichs-Elektrodenschichten.

- Figur 2B: zeigt eine sukzessive Änderung der kreisförmigen Struktur der Übergangsbereichs-Elektrodenschichten.

Der Piezoaktor 1 ist ein Piezoaktor mit einem Gesamtstapel 10 in monolithischer Vielschichtbauweise. Der Piezoaktor 1 weist einen piezoelektrisch aktiven Teilstapel 11 mit alternierend übereinander angeordneten Piezokeramikschichten 111 mit Bleizirkonattitanat (PZT) als piezokeramischen Werkstoff und Elektrodenschichten 112 aus einer Silber-Palladium-Legierung auf.

Über dem piezoelektrisch aktiven Teilstapel 11 ist ein piezoelektrisch inaktiver Abschlussbereich 12 in Form eines keramischen Deckpakets aus keramischen Schichten angeordnet.

Zwischen dem piezoelektrisch aktiven Teilstapel 11 und dem Deckpaket 12 ist ein Übergangsbereich 13 in Form eines Übergangsbereichs-Stapels angeordnet. Der Übergangsbereichs-Stapel 13 weist alternierend übereinander angeordnete Übergangsbereichs-Piezokeramikschichten 131 und Übergangsbereichs-Elektrodenschichten 132 auf. Der piezokeramische Werkstoff der Übergangsbereichs-Piezokeramikschichten und der piezokeramische Werkstoff der Piezokeramikschichten des piezoelektrisch aktiven Teilstapels 11 sind gleich. In einer alternativen Ausgestaltung sind die piezokeramischen Werkstoffe unterschiedlich.

Der piezoelektrisch aktive Teilstapel 11, der Übergangsbereichs-Stapel 13 und der Abschlussbereich 12 bilden zusammen einem monolithischen Gesamtstapel 10. An einer Seitenfläche des Gesamtstapels im Bereich des aktiven Teilstapels 11 und im Bereich des Übergangsbereichs-Stapels 13 ist eine Außenmetallisierung 14 zur elektrischen Kontaktierung der jeweiligen Elektrodenschichten angebracht. Zur alternierenden Kontaktierung ist eine weitere, nicht dargestellte Außenmetallisierung vorhanden.

Die Gesamthöhe 103 des Gesamtstapels 10 in Stapelrichtung 101 beträgt 30 mm. Die Teilstapelhöhe 113 piezoelektrisch aktiven Teilstapels 11 beträgt etwa 10 mm. Die Übergangsbereichs-Teilstapelhöhe 114 des Übergangsbereichs-Stapels 13 beträgt etwa 2 mm.

Die Übergangsbereichs-Piezokeramikschichten 131 und die Übergangsbereichs-Elektrodenschichten 132 sind derart ausgestaltet und aneinander angeordnet, dass in Stapelrichtung 133 des Übergangsbereichs-Stapels 13 von Übergangsbereichs-Piezokeramikschicht zu Übergangsbereichs-Piezokeramikschicht sukzessive eine Drehung 135 der Hauptachse 134 der Polung vorhanden ist. Alternativ ist eine Drehung 135 der Hauptachse 134 der elektrischen Ansteuerung vorhanden.

Die Drehung 135 der jeweiligen Hauptachse 134 beinhaltet die Drehung der Hauptachse 134 von einer im Wesentlichen zur Stapelrichtung 133 des Übergangsbereichs-Teilstapels 13 parallelen Ausrichtung (im Grenzbereich 121 zwischen dem aktiven Teilstapel 11 und dem Übergangsbereichs-Stapel 13) in eine im Wesentlichen zur Stapelrichtung 133 des Übergangsbereichs-Teilstapels 13 senkrechte Ausrichtung (im Grenzbereich zwischen dem Übergangsbereichs-Stapel 13) und dem piezoelektrisch inaktiven Deckpaket 12.

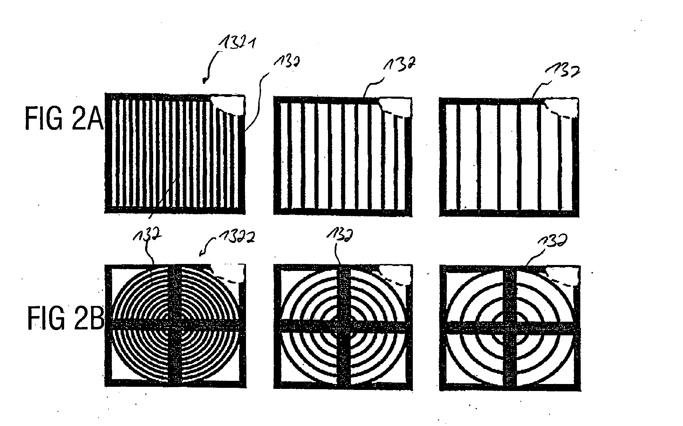

Die Übergangsbereichs-Elektrodenschichten 132 weisen gemäß einer ersten Ausführungsform eine kammartige Struktur auf.
Diese kammartige Struktur 1321 ist in Figur 2A angedeutet. Gemäß diesem Ausführungsbeispiel wird die kammartige Struktur 1321 der Übergangsbereichs-Elektrodenschichten 132 sukzessive geändert. Wie in Figur 2A angedeutet, wird ein Abstand zwischen Stegen der kammartigen Struktur 1321 von Übergangsbereichs-Elektrodenschicht zu Übergangsbereichs-Elektrodenschicht verändert. Benachbarte Übergangsbereichs-Elektrodenschichten 132 bilden zusammen jeweils eine Interdigital-Struktur 134.

Gemäß einer alternativen Ausführungsform weisen die Übergangsbereichs-Elektrodenschichten 132 eine kreisförmige Struktur 1322 auf (Figur 2B). Hier werden die Abstände zwischen den Kreisen der kreisförmigen Struktur 1322 von Übergangsbereichs-Elektrodenschicht zu Übergangsbereichs-Elektrodenschicht variiert.

Weitere Ausführungsbeispiele ergeben sich dadurch, dass nicht nur bzw. alternativ zur dargestellten Anordnung des Abschlussbereichs 12 und des Übergangsbereichs 13 im Kopfbereich des Gesamtstapels 10 der Abschlussbereich 12 und der Übergangsbereich im Fußbereich des Gesamtstapels 10 angeordnet wird.

Dieser neue Piezoaktor 1 wird zur Ansteuerung eines Einspritzventils eines Motors eines Kraftfahrzeugs verwendet.

## Patentansprüche

1. Piezoaktor (1) in monolithischer Vielschichtbauweise, aufweisend
- mindestens einen piezoelektrisch aktiven Teilstapel, wobei der Teilstapel übereinander angeordnete Piezokeramikschichten (111, 121) und zwischen den Piezokeramikschichten angeordnete Elektrodenschichten (112, 122) aufweist,
- mindestens einen, über dem piezoelektrisch aktiven Teilstapel angeordneten piezoelektrisch inaktiven Abschlussbereich und
- mindestens einen zwischen dem piezoelektrisch aktiven Teilstapel und dem Abschlussbereich angeordneten Übergangsbereich, wobei
- der piezoelektrisch aktive Teilstapel, der Abschlussbereich und der Übergangsbereich zu einem monolithischen Gesamtstapel miteinander verbunden sind,
**dadurch gekennzeichnet, dass**
- der Übergangsbereich einen Übergangsbereichs-Stapel mit übereinander angeordneten Übergangsbereichs-Piezokeramikschichten und zwischen den Übergangsbereichs-Piezokeramikschichten angeordneten Übergangsbereichs-Elektrodenschichten aufweist und
- die Übergangsbereichs-Piezokeramikschichten und die Übergangsbereichs-Elektrodenschichten derart ausgestaltet und aneinander angeordnet sind, dass in Stapelrichtung des Übergangsbereichs-Stapels von Übergangsbereichs-Piezokeramikschicht zu Übergangsbereichs-Piezokeramikschicht sukzessive eine Drehung einer Hauptachse der Polung und/oder eine Drehung einer Hauptachse der elektrischen Ansteuerung vorhanden ist.

2. Piezoaktor nach Anspruch 1, wobei die Hauptachse im Grenzbereich zwischen dem Übergangsbereichs-Teilstapel und dem piezoelektrisch aktiven Teilstapel im Wesentlichen parallel zur Stapelrichtung des Übergangsbereichs-Teilstapels ausgerichtet ist.

3. Piezoaktor nach Anspruch 1 oder 2, wobei die Drehung durch Änderung einer Struktur und/oder einer Abmessung der Übergangsbereichs-Elektrodenschichten hervorgerufen ist.

4. Piezoaktor nach Anspruch 3, wobei die Struktur parallel zur lateralen Ausdehnung der jeweiligen Übergangsbereichs-Elektrodenschicht kammartig ist.

5. Piezoaktor nach Anspruch 3, wobei die Struktur parallel zur lateralen Ausdehnung der jeweiligen Übergangsbereichs-Elektrodenschicht kreisförmig ist.

6. Piezoaktor nach einem der Ansprüche 1 bis 5, wobei benachbarte Übergangsbereichs-Elektrodenschichten eine Interdigital-Struktur bilden.

7. Piezoaktor nach einem der Ansprüche 1 bis 6, wobei der aktive Teilstapel und/oder der Abschlussbereich eine aus dem Bereich von einschließlich 1 mm bis einschließlich 10 mm und insbesondere eine aus dem Bereich von einschließlich 3 mm bis einschließlich 5 mm ausgewählte Teilstapelhöhe aufweist.

8. Piezoaktor nach einem der Ansprüche 1 bis 7, wobei der Übergangsbereich-Teilstapel eine aus dem Bereich von einschließlich 0,2 bis einschließlich 5,0 mm und insbesondere von einschließlich 0,5 bis einschließlich 2,0 mm ausgewählte Übergangsstapelhöhe aufweist.

9. Piezoaktor nach einem der Ansprüche 1 bis 8, wobei der Gesamtstapel eine Gesamtstapelhöhe (103) aufweist, die aus dem Bereich von einschließlich 10 mm bis einschließlich 200 mm ausgewählt ist.

10. Verwendung eines Piezoaktors nach einem der Ansprüche 1 bis 9 zur Ansteuerung eines Ventils und insbesondere eines Einspritzventils einer Brennkraftmaschine.

## Claims

1. Piezoactuator (1) with a monolithic multi-layered construction, comprising
- at least one piezoelectric active partial stack, with the partial stack comprising piezoceramic layers (111, 121) arranged one above the other and electrode layers (112, 122) arranged between the piezoceramic layers,
- at least one piezoelectric inactive terminating region arranged above the piezoelectric active partial stack and
- at least one transition region arranged between the piezoelectric active partial stack and the terminating region, with
- the piezoelectric active partial stack, the terminating region and the transition region being connected with one another to form a monolithic total stack,
**characterized in that**
- the transition region comprises a transition region stack with transition region piezoceramic layers arranged one above the other and transition region electrode layers arranged between the transition region piezoceramic layers and
- the transition region piezoceramic layers and the transition region electrode layers being in a form and arranged on one another such that from transition region piezoceramic layer to transition region piezoceramic layer in the stack direction of the transition region, there is a rotation of a main axis of the poling vector and/or a rotation of a main axis of the electrical drive.

2. Piezoactuator according to claim 1, with the main axis in the boundary region between the transition region partial stack and the piezoelectric active partial stack essentially being aligned in parallel to the stack direction of the transition region partial stack.

3. Piezoactuator according to claim 1 or 2, with the rotation being caused by a change in the structure and/or a dimension of the transition region electrode layers.

4. Piezoactuator according to claim 3, with the structure parallel to the lateral dimension of the respective transition region electrode layer being formed like a comb.

5. Piezoactuator according to claim 3, with the structure parallel to the lateral dimension of the respective transition region electrode layer being shaped like a ring.

6. The piezoactuator as claimed in one of claims 1 to 5, with adjacent transition region electrode layers forming an interdigital structure.

7. Piezoactuator according to one of claims 1 to 6, with the active partial stack and/or the terminating region comprising a partial stack height selected from the range 1mm to 10mm inclusive, and in particular one from the range 3mm to 5mm inclusive.

8. Piezoactuator according to one of claims 1 to 7, with the transition region partial stack comprising a transition stack height selected from the range 0.2 mm to 5.0 mm inclusive and in particular from 0.5 mm to 2.0 mm inclusive.

9. Piezoactuator according to one of claims 1 to 8, with the total stack having a total stack height (103) that is selected from the range 10mm to 200 mm inclusive

10. Use of a piezoactuator according to one of claims 1 to 9 for operating a valve and in particular an injection valve of an internal combustion engine.

## Revendications

1. Actionneur piézo-électrique (1) dans un mode de construction multicouche monolithique, présentant
- au moins une pile partielle active piézo-électriquement, la pile partielle présentant des couches piézocéramiques (111, 121) disposées les unes au-dessus des autres et des couches d'électrodes (112, 122) disposées entre les couches piézocéramiques,
- au moins une zone de terminaison inactive piézo-électriquement et disposée au-dessus de la pile partielle active piézo-électriquement et
- au moins une zone de transition disposée entre la pile partielle active piézo-électriquement et la zone de terminaison,
- la pile partielle active piézo-électriquement, la zone de terminaison et la zone de transition étant reliées les unes avec les autres pour former une pile globale monolithique,
**caractérisé en ce que**
- la zone de transition présente une pile de zone de transition avec des couches piézocéramiques de zone de transition disposées les unes au-dessus des autres et des couches d'électrode de zone de transition disposées entre les couches piézocéramiques de zone de transition et
- les couches piézocéramiques de zone de transition et les couches d'électrode de zone de transition sont conçues et disposées les unes contre les autres de telle sorte que, dans le sens d'empilement de la pile de zone de transition, depuis la couche piézocéramique de zone de transition vers la couche piézocéramique de zone de transition, on a successivement une rotation d'un axe principal de la polarisation et/ou une rotation d'un axe principal de l'activation électrique.

2. Actionneur piézo-électrique selon la revendication 1, l'axe principal dans la zone limite entre la pile partielle de zone de transition et la pile partielle active piézo-électriquement est orienté essentiellement parallèlement à la direction d'empilement de la pile partielle de zone de transition.

3. Actionneur piézo-électrique selon la revendication 1 ou 2, la rotation étant provoquée par une modification d'une structure et/ou d'une dimension des couches d'électrodes de zone de transition.

4. Actionneur piézo-électrique selon la revendication 3, la structure étant en forme de peigne parallèlement à l'extension latérale de la couche d'électrode de zone de transition respective.

5. Actionneur piézo-électrique selon la revendication 3, la structure étant circulaire parallèlement à l'extension latérale de la couche d'électrode de zone de transition respective.

6. Actionneur piézo-électrique selon l'une quelconque des revendications 1 à 5, des couches d'électrode de zone de transition voisines formant une structure interdigitale.

7. Actionneur piézo-électrique selon l'une quelconque des revendications 1 à 6, la pile partielle active et/ou la zone de terminaison présentant une hauteur de pile partielle sélectionnée dans la plage de 1 mm inclus jusqu'à 10 mm inclus et en particulier une hauteur de pile partielle sélectionnée dans la plage allant de 3 mm inclus jusqu'à 5 mm inclus.

8. Actionneur piézo-électrique selon l'une quelconque des revendications 1 à 7, la pile partielle de zone de transition présentant une hauteur de pile de transition sélectionnée dans la plage allant de 0,2 mm inclus jusqu'à 5,0 mm inclus et en particulier dans la plage allant de 0,5 mm inclus jusqu'à 2,0 mm inclus.

9. Actionneur piézo-électrique selon l'une quelconque des revendications 1 à 8, la pile globale présentant une hauteur de pile globale (103) qui est sélectionnée dans la plage allant de 10 mm inclus jusqu'à 200 mm inclus.

10. Utilisation d'un actionneur piézo-électrique selon l'une quelconque des revendications 1 à 9 pour l'activation d'une vanne et en particulier d'une vanne d'injection d'un moteur à combustion interne.
